# EUROPÄISCHE PATENTANMELDUNG

(11) **EP 0 966 021 A2**
(43) Veröffentlichungstag der Anmeldung: **22.12.1999**
(21) Anmeldenummer: 99107956.7
(22) Anmeldetag: 22.04.1999
(51) Int. Cl.: H01J 37/34

(54) **Vorrichtung zum Beschichten von Substraten in einer Vakuumkammer**

(30) Priorität: 19.06.1998 DE 19827461
(71) Anmelder: Leybold Systems GmbH, 63450 Hanau (DE)
(72) Erfinder: Rick, Alfred, 63791 Karlstein (DE); Eberhardt, Helmut, 63584 Gründau (DE); Michael, Klaus Dr., 63571 Gelnhausen (DE); Krempel-Hesse, Jörg Dr., 63683 Eckartsborn (DE)

(57) **Zusammenfassung**

Bei einer Vorrichtung zum Beschichten von Substraten (10) mit dünnen Schichten, mit einer Vakuumkammer (1), einem zu zerstäubenden, in der Vakuumkammer (1) dem Substrat (10) gegenüberliegend angeordneten Target (69, mit Magneten (19,19',...; 20,20',...) zur Erzeugung eines magnetischen Tunnels vor der zu zerstäubenden Fläche des Targets (6), einem Einlaß (8) für ein Prozeßgas in den Prozeßraum (11), einer gegenüber der Vakuumkammer (1) elektrisch isolierten Anode (12) und einer Strom-Spannungs-Versorgung zur Erzeugung eines Plasmas vor dem Target (6)ist das Target (6) als rotationssymmetrischer Körper ausgeformt, der das Substrat (10) ringförmig umschließt, wobei die Magnete (19,19',...; 20,20',...) auf der dem Substrat (10) abgekehrten Seite des hohlzylindrischen Targets (6) gelagert und um die Rotationsachse (R) des Targets (6) herum bewegbar sind, wobei das Substrat (10) gegenüber der Vakuumkammer (1) elektrisch isoliert und am Boden des Prozeßraumes (1) ein die Anode (12) bildendes Teil von einem Isolator (13) gehalten ist.

## Beschreibung

Die Erfindung betrifft eine Vorrichtung zum Beschichten von Substraten mit dünnen Schichten mit einer Vakuumkammer, einem zu zerstäubenden, in der Vakuumkammer dem Substrat gegenüberliegend angeordneten Target, mit Magneten zur Erzeugung eines magnetischen Tunnels vor der zu zerstäubenden Fläche des Targets, einem Einlaß für ein Prozeßgas in die Vakuumkammer, einer gegenüber der Vakuumkammer elektrisch isolierten Anode und einer Strom-Spannungs-Versorgung zur Erzeugung eines Plasmas vor dem Target.

Bekannt ist eine Einrichtung zur Durchführung vakuumtechnologischer Prozesse in magnetfeldverstärkten elektrischen Entladungen (DD 123 952), bestehend aus einer magnetfelderzeugenden Einrichtung und einem Target mit negativem Potential und einer Anode, zwischen denen die elektrische Entladung brennt, wobei die magnetfelderzeugende Einrichtung mit ihren Polschuhen ringförmig und konzentrisch zur Kathode ausgebildet ist und entsprechend dem durchzuführenden vakuumtechnologischen Prozeß im Inneren des rohrförmigen Targets oder außen herum angeordnet ist und in Achsenrichtung begrenzte inhomogene, torusförmige Magnetfelder erzeugt, deren Hauptfeldrichtung im Bereich des Targets parallel zu dessen Achsenrichtung gerichtet ist und die Anode bei Anordnung der magnetfelderzeugenden Einrichtung im Target dieses rohrförmig umgibt und bei Anordnung um das Target in diesem als Rohr oder Vollmaterial angeordnet ist, wobei die magnetfelderzeugende Einrichtung, das rohrförmige Target und die Anode relativ zueinander bewegbar sind.

Bekannt ist weiterhin eine Einrichtung zum Hochratezerstäuben nach dem Plasmatronprinzip (DD 217 964 A3), bestehend aus einer magnetfelderzeugenden Einrichtung mit Ringspalt, einem gekühlten rohrförmigen Target und einer Anode, wobei die magnetfelderzeugende Einrichtung einen in sich geschlossenen, langgestreckten Ringspalt besitzt, in dem das Target so angeordnet ist, daß ihre große Achse parallel zur Targetachse verläuft, wobei eine Anode das Target so umgibt, daß der Ringspaltbereich frei ist und mittels einer Verstelleinrichtung der Abstand zwischen der Anode und der Targetoberfläche auf einen festen wert einstellbar ist und zum Erzeugen einer Relativbewegung um die große Achse zwischen dem Target und der magnetfelderzeugenden Einrichtung ein Antrieb angeordnet ist und an der magnetfelderzeugende Einrichtung eine Vorrichtung zur Veränderung des Abstandes zwischen dieser und dem Target angeordnet ist.

Weiterhin ist eine Kathode zur Vakuumzerstäubung bekannt (EP 0 461 035 B1), umfassend einen Hohlkörper im wesentlichen in Form eines Rotationskörpers, welcher um seine Achse rotieren kann, mit einer Seitenwand, die sich entlang der Achse erstreckt, und zwei Stirnseiten im wesentlichen senkrecht zur Achse, wobei der Hohlkörper mindestens am Äußeren seiner Seitenwand aus zu zerstäubendem Material gebildet ist, mit einem Magnetkreis zum magnetischen Einschluß, der nahe einem Target vorgesehen ist, und Pole, Teile aus magnetisch-permeablem Metall und Magnetisiermittel, die zur Erzeugung eines magnetischen Flusses in dem Magnetkreis geeignet sind, und mit einer Einrichtung zur Verbindung mit einem Kühlkreis für die Zirkulierung einer Kühlflüssigkeit in dem Hohlkörper, mit einer Einrichtung zur Verbindung mit einem elektrischen Versorgungskreis, und mit einer Triebeinrichtung zur Drehung des Hohlkörpers um eine Achse, wobei der Magnetkreis sich peripher in Bezug auf den Hohlkörper erstreckt, das Magnetisiermittel außerhalb diesem vorgesehen ist, die Pole des Magnetkreises entlang zweier Erzeugenden dieses Hohlkörpers vorgesehen sind und einen Bogen der Seitenwand des Hohlkörpers, der sich zwischen diesen beiden Erzeugenden befindet, das Target der Kathode bildet.

Schließlich hat man bereits eine Vorrichtung zur Aufstäubung von dünnen Filmen eines ausgewählten Überzugsmaterials auf wesentlich planare Substrate vorgeschlagen (EP 0 070 899 B1), bestehend aus einer evakuierbaren Beschichtungskammer, einer in dieser Beschichtungskammer horizontal angebrachten Kathode mit einem länglichen, zylindrischen Rohrelement, auf dessen äußerer Fläche eine Schicht des zu zerstäubenden Überzugsmaterials aufgetragen ist und mit Magnetmitteln, die in diese Rohrelement angeordnet sind, um eine sich in Längsrichtung davon erstreckende Zerstäubungszone vorzusehen, wobei Mittel zum Drehen dieses Rohrelements um seine Längsachse vorgesehen sind, um verschiedene Teile des Überzugsmaterials in eine Zerstäubungsstellung gegenüber den vorerwähnten Magnetmitteln und innerhalb der vorerwähnten Zerstäubungszone zu bringen und mit in der Beschichtungskammer befindlichen Mitteln zum horizontalen Abstützen der Substrate und zum Transportieren dieser an den Magnetmitteln vorbei, damit diese Substrate des zerstäubte Material empfangen.

Der vorliegenden Erfindung liegt die Aufgabe zugrunde, eine Vorrichtung der in Frage stehenden Art zu schaffen, die eine besonders hohe Targetausnutzung gewährleistet und gleichzeitig eine hohe Beschichtungsrate ermöglicht, um einzelne Substrate mit hohem Durchsatz beschichten zu können.

Diese Aufgabe wird erfindungsgemäß dadurch gelöst, daß das Target als rotationssymmetrischer Körper ausgeformt ist und das Substrat ringförmig umschließt und die Magnete auf der dem Substrat abgekehrten Seite des hohlzylindrischen Targets gelagert und um die Targetlängsachse rotierbar sind, wobei das Substrat gegenüber der Vakuumkammer elektrisch isoliert ist und am Boden der Vakuumkammer ein eine Anode bildendes Teil von einem Isolator gehalten ist.

Die Erfindung läßt die verschiedensten Ausführungsmöglichkeiten zu; eine davon ist in der anhängenden Zeichnung rein schematisch näher dargestellt, die eine Vorrichtung im Längsschnitt und im Querschnitt zeigt.

Die Vorrichtung besteht im wesentlichen aus einem hohlzylindrischen Gehäuse 3 mit einem kreisscheibenförmigen Bodenstück 4 mit Saugpumpenanschluß 2, einem ebenfalls etwa kreisscheibenförmigen Deckel 5, einem hohlzylindrischen Target 6, einem Isolator 7 mit Gaseinlaßstutzen 8 und der Durchführung für eine elektrische Anschlußleitung 9, dem vom Isolator 7 im Vakuumraum 11 gehaltenen Substrat 10, einem eine Anode 12 mit Isolatorring 13 haltenden Zwischenboden 14 mit Öffnung 15,15', einer elektrischen Zuleitung 16 für die Anode 12 und den beiden um die Längsachse R (in Pfeilrichtung P₁ oder P₂) rotierbaren Magnetsätzen 17,17', die jeweils aus einem Magnetjoch 18,18' und Permanentmagneten 19,19',... bzw. 20,20',... unterschiedlicher Polung gebildet sind.

Während des Beschichtungsverfahrens rotieren die Magnetsätze 17,17' um den hohlzylindrischen Teil der Vakuumkammer 1, wobei ein Plasma im Prozeßraum 11 zwischen Substrat 10 und Target 6 brennt und die abgesputterten Teilchen sich von der Targetinnenfläche radial nach innen zu zum Substrat 1 bewegen.

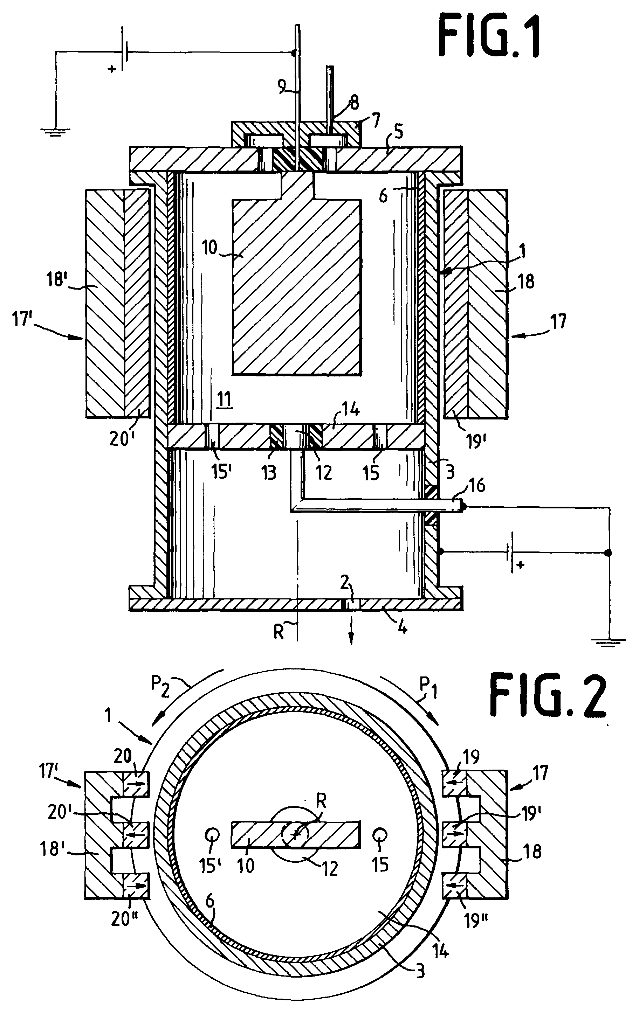

## Patentansprüche

1. Vorrichtung zum Beschichten von Substraten (10) mit dünnen Schichten, mit einer Vakuumkammer (1), einem zu zerstäubenden, in der Vakuumkammer (1) dem Substrat (10) gegenüberliegend angeordneten Target (69, mit Magneten (19,19',...; 20,20',...) zur Erzeugung eines magnetischen Tunnels vor der zu zerstäubenden Fläche des Targets (6), einem Einlaß (8) für ein Prozeßgas in den Prozeßraum (11), einer gegenüber der Vakuumkammer (1) elektrisch isolierten Anode (12) und einer Strom-Spannungs-Versorgung zur Erzeugung eines Plasmas vor dem Target (6)**, dadurch gekennzeichnet**, daß das Target (6) als rotationssymmetrischer Körper ausgeformt ist und das Substrat (10) ringförmig umschließt und die Magnete (19,19',...; 20,20',...) auf der dem Substrat (10) abgekehrten Seite des hohlzylindrischen Targets (6) gelagert und um die Rotationsachse (R) des Targets (6) herum bewegbar sind, wobei das Substrat (10) gegenüber der Vakuumkammer (1) elektrisch isoliert und am Boden des Prozeßraumes (1) ein die Anode (12) bildendes Teil von einem Isolator (13) gehalten ist.
